# EUROPEAN PATENT SPECIFICATION

(11) **EP 2 840 675 B1**
(45) Date of publication and mention of the grant of the patent: **14.11.2018**
(21) Application number: 14179801.7
(22) Date of filing: 05.08.2014
(51) Int. Cl.: H02J 3/38, G01R 33/02, H02J 3/18

(54) **Electrical power distribution network monitoring and control**
Stromverteilungsnetzüberwachung und -steuerung
Surveillance et contrôle de réseau de distribution d'énergie électrique

(30) Priority: 08.08.2013 US 201313962441
(43) Date of publication of application: 25.02.2015
(73) Proprietor: The Boeing Company, Chicago, IL 60606-1596 (US)
(72) Inventor: Peck Jr., James Leo, Chicago, IL 60606-2016 (US)
(74) Representative: Boult Wade Tennant LLP

(56) References cited:
- WO-A2-2007/078403
- DE-A1- 2 926 423
- US-A- 4 020 440
- US-A1- 2012 150 679
- US-A1- 2012 226 386
- US-A1- 2013 043 725
- US-A1- 2013 049 751

## Description

### FIELD

The present disclosure relates to electrical power distribution networks or systems, and more particularly to a system and method for monitoring and controlling components of an electrical power distribution network or system.

### BACKGROUND

Electrical power distribution networks represent challenges in monitoring in real-time for efficient operation and to prevent faults or other conditions that could potentially cause damage to components of the power distribution network or to loads or equipment of electrical power consumers connected to the power distribution network. Aircraft, ships and municipal electrical power distribution systems or networks depend on voltage, current and thermal monitoring systems to protect components of these systems or networks from potentially being damaged due to electrical faults or other anomalies, such as lightning strikes or other natural occurrences, human causes or other changes associated with the network. These systems may respond to changes in performance over a period of time. Alternating current (AC) voltage and current are typically averaged over many cycles and thermal changes may be averaged over several minutes before any actions may be taken. Accordingly, such measurements and evaluations may be slow in responding to critical changes to performance of the electrical distribution network or system.
US20130043725A1 relates to a method of managing transmission of power in a power transmission network, said method comprising the steps of: establishing utility grid characteristic comprising at least one reference value based on at least one parameter reflecting the state of said transformer, continuously monitoring said at least one parameter reflecting the state of said transformer, and continuously controlling power consumption and/or power production at the lower voltage side of said transformer based on said monitoring of said at least one parameter reflecting the state of said transformer, said controlling of said power consumption and/or said power production comprising regulating said power consumption of one or more of said plurality of power consumers and/or regulating said power production of one or more decentralized power producers located at said lower voltage side of said transformer, so as to comply with said established reference value.

### SUMMARY

In accordance with the invention an electrical power distribution network comprises the features of claim 1.

### BRIEF DESCRIPTION OF THE SEVERAL VIEWS OF DRAWINGS

The following detailed description of embodiments refers to the accompanying drawings, which illustrate specific embodiments of the disclosure. Other embodiments having different structures and operations do not depart from the scope of the present disclosure.
Figure 1 is block schematic diagram of an example of an electrical power distribution network in accordance with an embodiment of the present disclosure.
Figure 2 is schematic diagram of an example of an electrical power distribution circuit within an electrical power distribution network in accordance with an embodiment of the present disclosure.
Figure 3 is a flow chart of an example of a method of operation of a central manager that monitors core flux sensor levels within an electrical power distribution network and controls power distribution within the network in accordance with an embodiment of the present disclosure.
Figure 4 is a block schematic diagram of an example an electromagnetic device and a core flux control system in accordance with an embodiment of the present disclosure.
Figure 5 is a side cross-sectional view of an example of an electromagnetic device and a core flux control system in accordance with an embodiment of the present disclosure.
Figure 6 is a top view of an example of a magnetic flux sensor plate or laminate in accordance with an embodiment of the present disclosure.
Figure 7 is a top view of an example of a spacer plate or laminate in accordance with an embodiment of the present discloser.
Figure 8 is a top view of an example of a magnetic core plate or laminate in accordance with an embodiment of the present disclosure.
Figure 9 is a flow chart of an example of a method for monitoring a magnetic core flux level in one or more transformers of an electrical power distribution network and controlling power distribution by the network in accordance with an embodiment of the present disclosure.
Figure 10 is a flow chart of an example of a method for controlling magnetic flux in an electromagnetic device for power management in accordance with an embodiment of the present disclosure.

### DESCRIPTION

The following detailed description of embodiments refers to the accompanying drawings, which illustrate specific embodiments of the disclosure. Other embodiments having different structures and operations do not depart from the scope of the present disclosure. Like reference numerals may refer to the same element or component in the different drawings.

In accordance with an embodiment of the present disclosure, a linear inductor is an electromagnetic device having only one electrical conductor wire winding or windings passing through a magnetic core. In accordance with another embodiment, a linear transformer is an electromagnetic device where a linear primary electrical conductor wire winding or windings and one or more linear secondary electrical conductor wire winding or windings pass through a magnetic core. The core may be one piece and no turns of the primary and secondary electrical conductors about the core are required. While the core may be one piece, the one piece core may be formed from a plurality of stacked plates or laminates. A current may be conducted through the primary. A magnetic flux from the current in the primary is absorbed by the core. When the current in the primary decreases the core transmits an electromotive force (desorbs) into the secondary wires. A feature of the linear transformer is the linear pass of the primary and secondary conductors through the core. One core may be used as a standalone device or a series of two or more cores may be used where a longer linear exposure is required. Another feature of this transformer is that the entire magnetic field or at least a substantial portion of the magnetic field generated by the current in the primary is absorbed by the core, and desorbed into the secondary. The core of the transformer may be sized or include dimensions so that substantially the entire magnetic field generated by the current is absorbed by the core and so that the magnetic flux is substantially completely contained with the core. This forms a highly efficient transformer with very low copper losses, high efficiency energy transfer, low thermal emission and very low radiated emissions. Additionally the linear transformer is a minimum of about 50% lower in volume and weight then existing configurations. Linear electromagnetic devices, such as linear transformers, inductors and similar devices are described in more detail in U.S. Patent Application Publication No. 2014/0022040 , entitled "Linear Electromagnetic Device". A magnetic core flux sensor assembly is described in more detail in U.S. Patent Application Publication No. 2014/0232383,
entitled "Magnetic Core Flux Sensor".

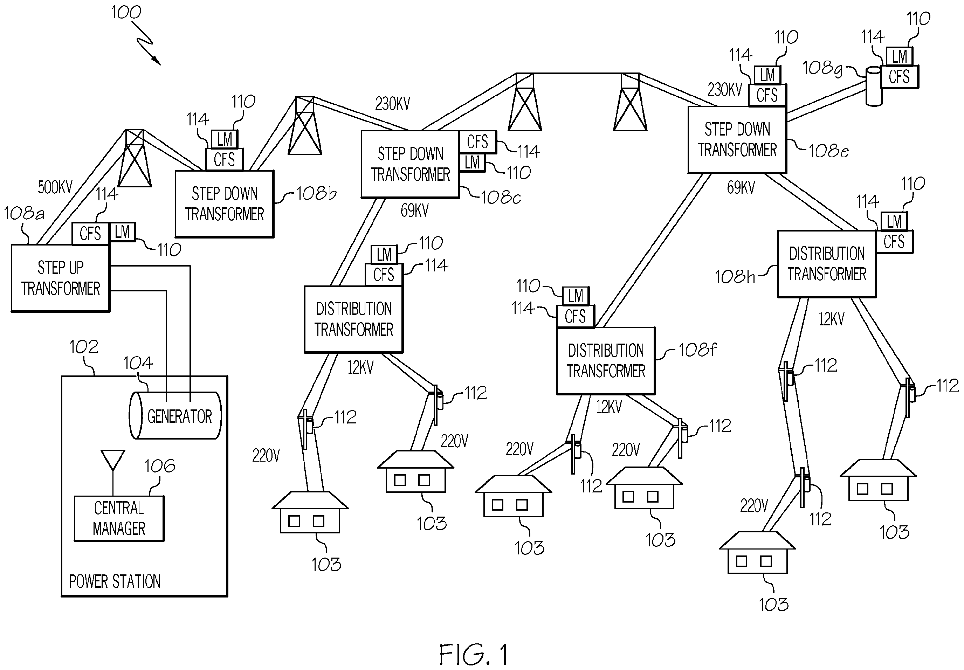

Figure 1 is block schematic diagram of an example of an electrical power distribution network 100 or system in accordance with an embodiment of the present disclosure. The electrical power distribution network 100 may include at least one power station 102 that generates electrical power which is distributed by the power distribution network 100 or system to end users or electrical power consumers 103. The power station 102 may include at least one generator 104 that generates electrical power for distribution over the electrical power distribution network 100. The power station 102 may also include a central manager 106. While the central manager 106 is shown as being part of the power station 102, in other embodiments, the central manager 106 may be separate from the power generation station 102.

The electrical power distribution network 100 may also include a plurality of transformers 108a-108h. The transformers 108a-108h may be different types of transformers, such as stepped-up transformers and step-down transformers. As is known in the art, a step-up transformer increases a voltage received by a primary conductor winding of the transformer which is transmitted by a secondary conductor winding of the transformer. A step-down transformer decreases the voltage received by the primary conductor winding of the transformer which is transmitted by the secondary conductor windings of the transformer.

A local manager 110 may be associated with each transformer 108a-108h. Each local manager 110 may be configured to monitor and control a magnetic flux level in a magnetic flux core of the associated transformer 108a-108h.

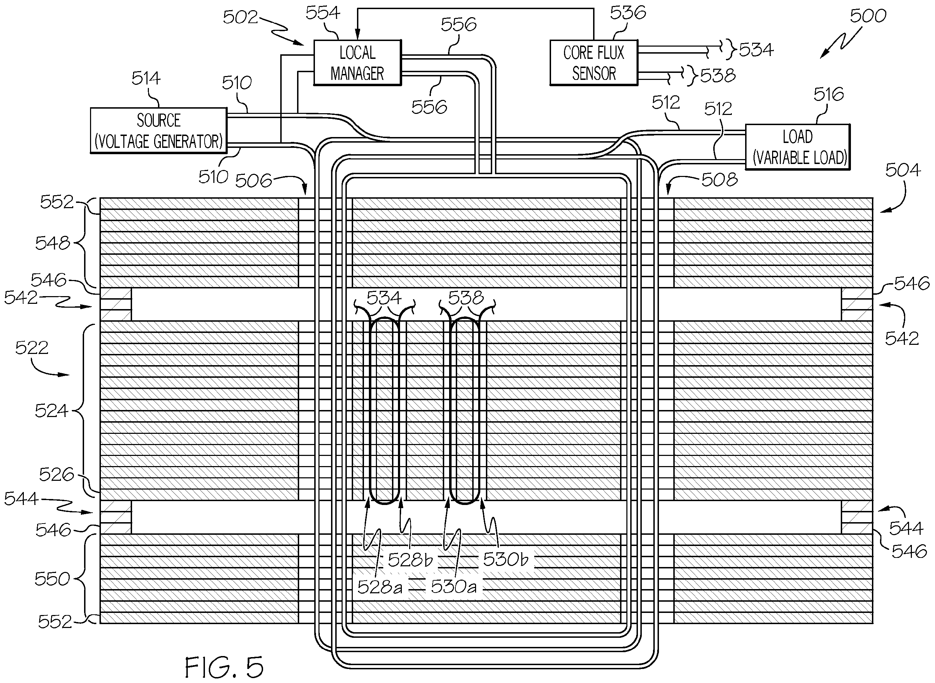

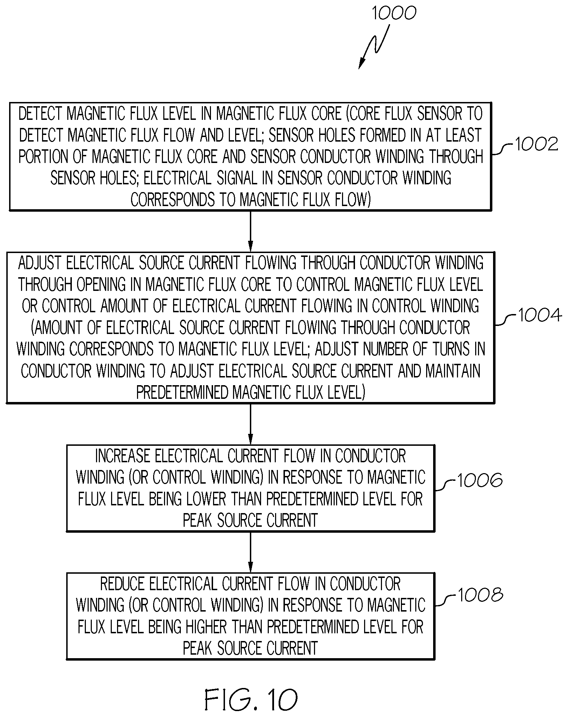

The electrical power distribution network 100 may also include other transformers 112 that may not have a local manager 110 associated with them. The central manager 106 may be configured to receive magnetic flux level data from each local manager 110 and may control operation of each local manager 110 in response to the magnetic flux level data. The central manager 106 may be configured to analyze the magnetic flux level data from each local manager 110 and transmit an individual instruction to at least some local managers 110 for controlling the magnetic flux level in the associated transformer 108a-108e in response to the analysis of the magnetic flux level data. Each local manager 110 may control a configuration of the associated transformer 108a-108h to control the magnetic flux flowing in a core of the associated transformer 108a-108e and thereby control a voltage and current supplied by the associated transformer 108a-108h. As described in more detail with respect to Figure 5 and Figure 10, the local manager 110 may control the configuration of the associated transformer 108a-108h by controlling a number of conductor windings in the primary of the transformer or by controlling an amount of current flowing in the primary conductor windings.

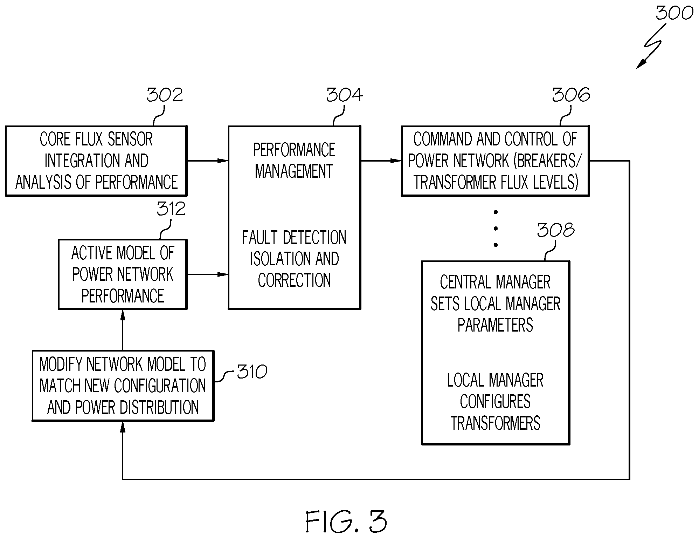

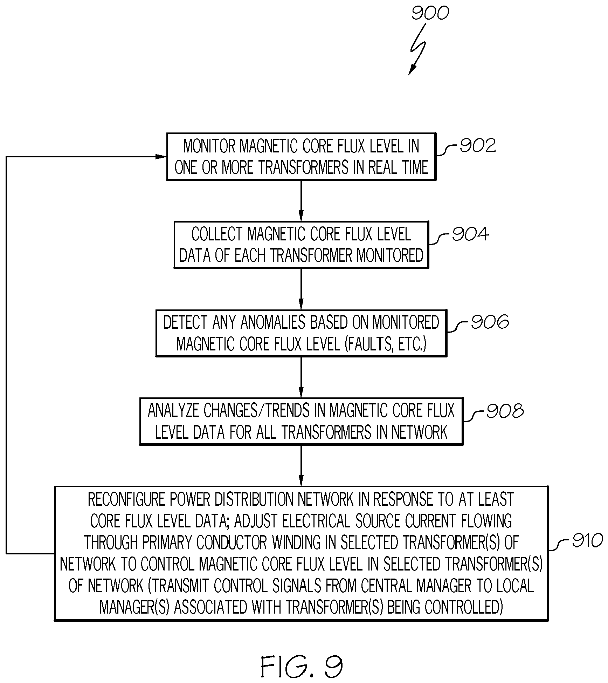

Communications between the central manager 106 and each of the local managers 110 may be via a wireless communications arrangement or a wired communications network. For example, the central manager 106 and each of the local managers 110 may include a radio frequency (RF) transceiver for communications with one another over a dedicated wireless RF communications network or may communicate over a public cellular telecommunications network or both. The central manager 106 and each of the local managers 110 may also each include a microprocessor or other computing device for performing the functions and operations described herein. An example of functions and operations that may be performed by the central manager 106 will be described in more detail with reference to the flow chart in Figure 3. An example of functions and operations that may be performed by the central manger 106 and the local mangers 110 in coordination with one another will be described with reference to the flow chart in Figure 9. An example of functions and operations that may be performed by each local manager 110 will be described in more detail with reference to the flow chart in Figure 10.

A core flux sensor arrangement 114 may be coupled to each local manager 110. The core flux sensor arrangement 114 may be configured to detect a magnetic flux level in the magnetic flux core of the associated transformer 108a-108h. The local manager 110 is configured to receive the magnetic flux level data and to adjust the electrical current flowing through a primary conductor windings of the associated transformer 108a-108h to control the magnetic flux level in the magnetic flux core and thereby control the current supplied by the secondary windings of the transformer 108a-108h. An example of a transformer including a core flux sensor arrangement and local manager will be described in more detail with reference to Figure 5. The local manager 110 and core flux sensor arrangement 114 may define at least part of a core flux control system as described with reference to Figure 5.

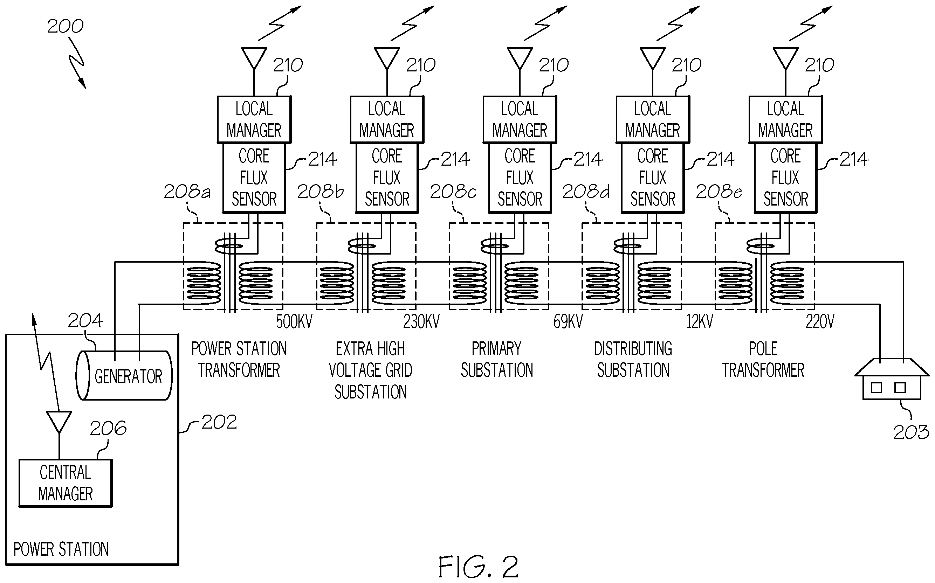

Figure 2 is schematic diagram of an example of an electrical power distribution circuit 200 between a power station 202 and an end user or consumer 203 of electrical power in accordance with an embodiment of the present disclosure. The electrical power distribution circuit 200 may be part of an electrical power distribution network, such as network 100 in Figure 1. The power station 202 may be similar to the power station 102 in Figure 1. The power station may include a generator 204 and a central manager 206. The central manager 206 may be similar to the central manager 106 of Figure 1 and may perform similar functions and operations. The central manager 206 may be configured to control a level of electrical power transmitted on the power distribution circuit 200 to the electrical power end user 203 or consumer.

The electrical power distribution circuit 200 may include a plurality of transformers 208a-208e. For example, the electrical power distribution circuit 200 may include a power station transformer 208a that may step-down the voltage from the power station generator 204 to 500 kilovolts (kV) on the secondary of the power station transformer 208a. An extra high voltage grid substation transformer 208b may be coupled to the power station transformer 208a and may step-down the voltage to 230 kV on the secondary of the extra high voltage grid substation transformer 208b. A primary substation transformer 208c may be coupled to the extra high voltage grid substation 208b and may step-down the voltage to 69 kV on the secondary of the primary substation transformer 208c. A distribution substation transformer 208d may be coupled to the primary substation transformer 208c and may step-down the voltage to 12 kV on the secondary of the distribution sub-station 208d. The electrical power distribution circuit 200 may further include a pole transformer 208e or ground transformer coupled to the distribution substation transformer 208d. The transformer 208e may step-down the voltage to 220 V supplied to the end user or consumer 203.

A local manager 210 may be associated with each of the transformers 208a-208e and each of the local managers 210 may be coupled to a core flux sensor arrangement 214. The local manager 210 and the core flux sensor arrangement 214 may be similar to the local manager 110 and core flux sensor arrangement 114 in Figure 1 and may operate in a similar manner.

Figure 3 is a flow chart of an example of a method 300 of operation of a central manager that monitors core flux sensor levels within an electrical power distribution network and controls power distribution within the network in accordance with an embodiment of the present disclosure. The method 300 may be embodied in and performed by the central manager 106 in Figure 1 or the central manager 206 in Figure 2. In block 302, the central manager may receive magnetic flux level data from each of the local managers. The central manager may be configured to integrate the magnetic flux level data from each of the local managers and evaluate performance of each of the transformers and the overall performance of the electrical power distribution network based on the magnetic flux level data.

In block 304, the central manager may manage performance of each of the local managers in controlling and configuring the associated transformers in the electrical power distribution network. For example, the central manager may be configured to detect a fault based on evaluation of the magnetic flux level data. The central manager may then transmit instructions to any affected local manager or local manager or managers associated with the fault to isolate the fault. The local manager may configure the associated transformer to isolate the fault and perform any corrective action in response to receiving the instructions from the central manager.

In block 306, the central manager may be configured to command and control the power distribution network by operating circuit breakers, switches or other electrical power distribution control devices to manage the distribution network based on analysis of the magnetic flux level data received from the local managers.

Similar to that previously described, the central manager may also be configured to control transformer flux levels in the transformers of the electrical power distribution circuit by transmitting instructions to the local managers associated with the transformers. The transformer flux levels may be controlled similar to that described with respect to Figure 10. For example, in block 308, the central manager may be adapted to set at least one local manager parameter. The at least one local manager parameter may be set by the instructions transmitted to the local manager by the central manager. The local manager may then configure the associated transformer in response to the at least one local manager parameter. For instance, the transformer may be configured by adjusting the number of primary conductor windings, controlling the amount of current in the primary conductor windings or by any other mechanism to control the magnetic flux level within the magnetic core of the associated transformer.

In block 310, a network model maintained by the central manager may be modified to match a new configuration of the electrical power distribution network in response to a change in the configuration of the electrical power distribution network in blocks 306 and 308 or changes in configuration of any transformers of the distribution network.

In block 312, an active model of the power distribution network performance is stored and maintained by the central manager.

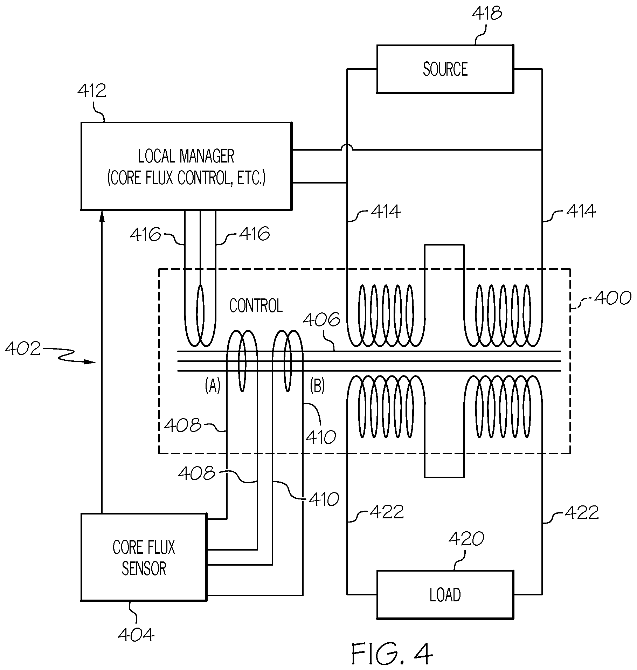

Figure 4 is a block schematic diagram of an example of an electromagnetic device 400 and a core flux control system 402 in accordance with an embodiment of the present disclosure. An example of a core flux control system that may be used for the core flux control system 402 is described in U.S. Patent Application Publication No. 2015/0028827, entitled "Transformer Core Flux Control for Power Management,". The core flux control system 402 may include a core flux sensor arrangement 404 or device that detects the magnetic flux flow in the magnetic flux core 406 of the electromagnetic device 400 and measures a level of the magnetic flux flow in the magnetic flux core 406. The core flux sensor arrangement 404 may detect the magnetic flux flow in the magnetic flux core 406 by one or more flux sensor windings 408 and 410 wound through an interior of the core 406 as described in more detail with reference to Figure 5. The core flux sensor arrangement 404 provides a signal corresponding to the magnetic flux level in the magnetic core 406 of the electromagnetic device 400 or transformer at a location of the flux sensor windings 408 and 410 to a local manager 412. The local manager 412 may include a core flux control device or may be a core flux control device similar to that described in U.S. Patent Application Publication No. 2015/0028827. The local manager 412 is configured to adjust the electrical current flowing through a primary conductor winding 414 or windings to control the magnetic flux level in the magnetic flux core 406. The local manager 412 may be configured to adjust a number of turns in the conductor winding by adding or subtracting turns to maintain a predetermined magnetic flux level in the magnetic flux core 406. For example, the core flux sensor arrangement 404 may detect the magnetic flux level in the magnetic flux core 406 when a peak source current is flowing through the primary conductor winding 414. The local manager 412 may increase the electrical current flow or increase an amplitude of the electrical current flowing through the primary conductor winding 414 in response to the magnetic flux level being lower than the predetermined level for the peak source current, and the local manager 412 may reduce the electrical current or reduce an amplitude of the current flowing through the conductor winding 414 in response to the level of the magnetic flux flow being higher than the predetermined level for the peak current.

As previously discussed, the local manager 412 may also be connected to an additional winding or control winding 416 or windings. In addition to controlling the amount or amplitude of current flowing in the primary conductor winding 414, the local manager 412 or core flux control device may also switch in or out the control winding 416 and may increase or decrease electrical current flowing in the control winding 416 to further control the magnetic flux level in the core 406.

The local manager 412 may also control or alternatively control an amount or amplitude of current in the primary conductor windings from an electrical source 418. The electromagnetic device 400 or transformer may provide electrical power to a load 420 coupled to the secondary winding or windings 422 of the electromagnetic device 400.

Figure 5 is a cross-sectional view of an example of an electromagnetic device 500 and core flux control system 502 in accordance with an embodiment of the present disclosure. The electromagnetic device 500 may be used for the electromagnetic device 400 in Figure 4. The electromagnetic device 500 and core flux control system 502 may also be embodied in each of the transformers 108a-108h, associated local managers 110 and associated core flux sensor arrangements 114 of Figure 1. The electromagnetic device 500 and core flux control system 5902 may further be embodied in the transformers 208a-208e, associated local managers 210 and associated core flux sensor arrangements 214 of Figure 4.

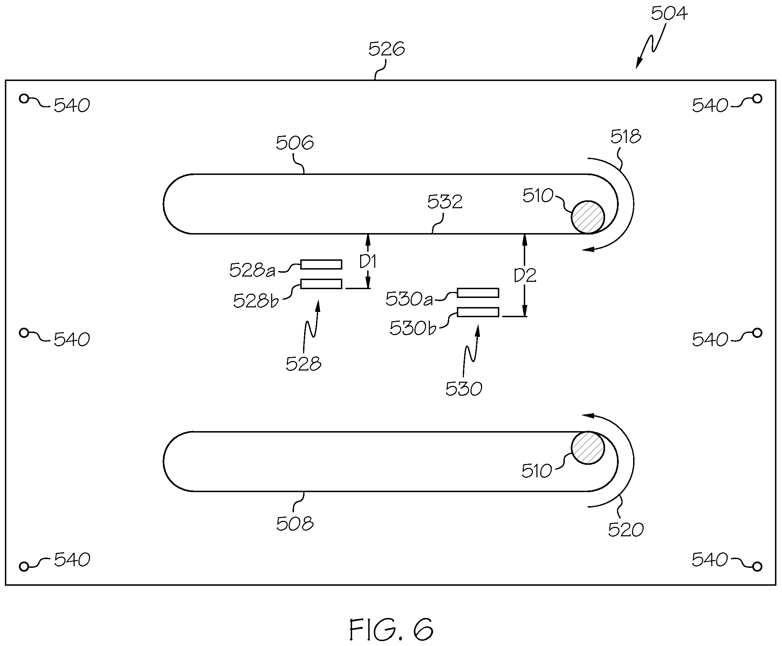

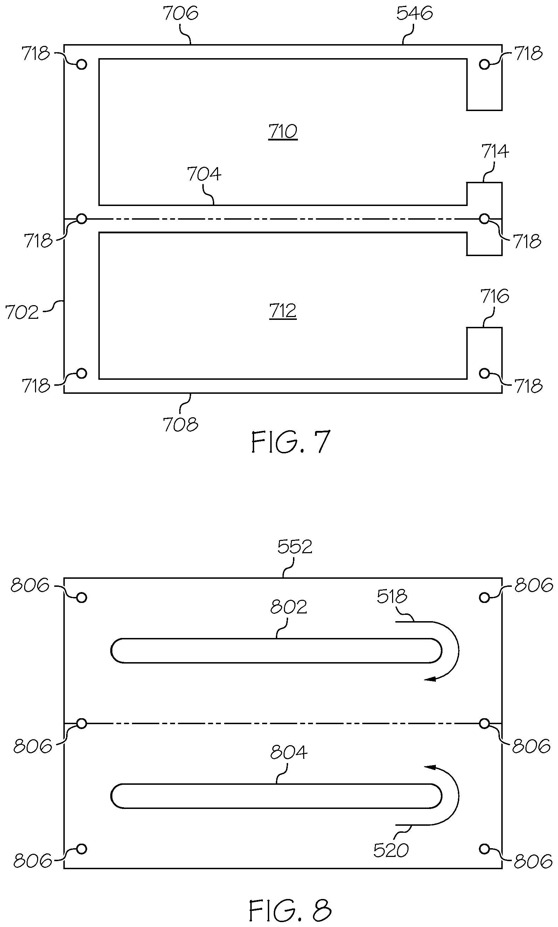

The electromagnetic device 500 may include a magnetic flux core 504. As described in more detail herein, the core flux control system 502 may be configured to adjust an electrical current flowing through a conductor winding to control a magnetic flux level in the magnetic flux core 504. A first opening 506 and a second opening 508 may be formed through the magnetic core 504. The first opening 506 and the second opening 508 may be elongated openings similar to that illustrated in Figures 6 and 8. The exemplary electromagnetic device 500 illustrated in Figure 5 may be configured as a transformer and may include a primary conductor winding 510 and a secondary conductor winding 512. The primary conductor winding 510 may extend through the first opening 506 and the second opening 508 and may be coupled to a source 514 of electrical power. The source 514 may be a voltage generator. The secondary conductor winding 512 may also extend through the first opening 506 and the second opening 508 and maybe coupled to a load 516. The load 516 may be a variable load. An electrical current flowing through the primary conductor winding 510 generates a magnetic field around the primary conductor winding 510 and a magnetic flux flow is created in the magnetic core 504 as illustrated by arrows 518 and 520 in Figures 6 and 8. The magnetic flux flow in the magnetic core 504 will be in opposite directions about the respective elongated openings 506 and 508, as illustrated by arrows 518 and 520, because of the direction of electric current flow in the primary winding 510 (Figure 5) through the elongated openings 506 and 508 and the right-hand rule. Based on the right-hand rule, electric current flowing into the page on Figure 6 in windings 510 through elongated opening 510 will cause a magnetic flux flow in the direction of arrow 518 in the example in Figure 6, and electric current flowing out of the page in the same windings 510 in Figure 6 through elongated opening 508 will cause a magnetic flux flow in the direction of arrow 520.

While the exemplary electromagnetic device 500 illustrated in Figure 5 has been described as having a first opening 506 and a second opening 508 through the magnetic flux core 504 and primary and secondary windings 510 and 512 through the openings 506 and 508, other embodiments may have a single opening. A primary conductor winding and a secondary conductor winding may extend through the single opening forming an electromagnetic device configured as a transformer. In another embodiment, a single conductor winding may extend through the single opening through the magnetic flux core. An electromagnetic device with a single conductor winding is configured as an inductor. The number and use of the windings determines whether the electromagnetic device is an inductor or transformer.

The electromagnetic device 500 may include a core flux sensor arrangement 522 to detect a magnetic flux level in the magnetic flux core 504. The magnetic flux core 504 of the electromagnetic device 500 may include a flux sensor core portion 524 that may be part of the core flux sensor arrangement 522. The flux sensor core portion 524 may include a plurality of flux sensor core plates 526 or laminates that are stacked on one another. Referring also to Figure 6, Figure 6 is a top view of an example of a magnetic flux sensor plate 526 or laminate in accordance with an embodiment of the present disclosure. Each sensor plate 526 of the flux sensor core portion 524 may include a first pair of sensor holes 528a and 528b and a second pair of sensor holes 530a and 530b for use in sensing a level of the magnetic flux flow 518 at a respective location of each of the first pair of sensor holes 528a and 528b and the second pair of sensor holes 530a and 530b. The first pair of sensor holes 528 and second pair of sensor holes 530 may be disposed along one longitudinal side or side with the longest dimension of the elongated opening 506. The first pair of sensor holes 528a and 528b may be a distance "D1" from an edge 532 of the opening 506 to the sensor hole 528b farthest from the edge 532 of the opening 506. The second pair of sensor holes 530a and 530b may be a distance "D2" from the edge 532 of the opening 506 to the sensor hole 530b farthest from the edge. The spacing between the sensor holes of each pair may be about half the distance "D1." The pairs of sensor holes 528 and 530 are positioned relative to the opening 506 through the magnetic flux core 504 for use in sensing the level of the magnetic flux flow 518 at different distances from the opening 506 while minimizing disruption of the magnetic flux flow 518 in the flux sensor core portion 524 of the magnetic flux core 504.

A sensor conductor winding 534 (Figure 5) extending through the first pair of sensor holes 528a and 528b and connects to a core flux sensor device 536. A second sensor conductor winding 538 extends through the second pair of sensor holes 530a and 530b and connects to the core flux sensor device 536. The sensor holes 528 and 530 may be substantially elongate as illustrated in Figure 6 for receiving the sensor windings 534 and 538 or the sensor holes 528 and 530 may be some other shape and size for receiving a particular shape and size of the sensor windings 534 and 538. The magnetic flux flow 518 generates an electrical signal in each of the sensor conductor winding 534 and 538. An amplitude of the electrical signal in each sensor conductor winding 534 and 538 corresponds to the level or magnitude of the magnetic flux flow at the respective location of each sensor conductor winding 534 and 538 or sensor holes 528 and 530. The core flux sensor device 536 may be an oscilloscope or other device for detecting the magnetic flux flow and measuring the level of the magnetic flux flow in the core 504 at the respective location of the pairs of sensor holes 528 and 530 and sensor windings 534 and 538. The sensor windings 534 and 538 define loop antenna sensors as described in more detail below. The core flux sensor arrangement 522 may include the sensor holes 528, 530, the sensor windings 534 and 538 through the sensor holes 528 and 530 and the core flux sensor device 536.

While the exemplary electromagnetic device 500 illustrated in Figure 1 has been described as having two pairs of sensor holes 528 and 530 and two sensor conductor windings 534 and 538, other embodiments may have a single pair of sensor holes and a single sensor winding or more than two pairs of sensor holes and sensor windings for use in detecting or measuring a magnetic flux level at different locations in a magnetic flux core.

The sensor plates 526 may be made from a material capable of absorbing a magnetic flux. For example, the plates 526 may be made from silicon steel alloy, a nickel-iron alloy or other metallic material capable of absorbing a magnetic flux similar to that described herein. In an embodiment, the core 504 may be a nickel-iron alloy including about 20% by weight iron and about 80% by weight nickel. The plates 526 may be substantially square or rectangular, or may be some other geometric shape depending on the application of the electromagnetic device 500 and the environment where the electromagnetic device may be located.

In accordance with another embodiment, rather than a plurality of pairs of sensor holes 528 and 530, there may be a plurality of single sensor holes. Each sensor hole may be positioned relative to the at least one elongated opening 506 for preventing significant disruption of the magnetic flux flow in the sensor core portion 522 and for use in sensing the magnetic flux flow at different distances from the edge 532 of the at least one elongated opening 506. The sensor conductor winding may be a single wire or antenna element in each single sensor hole. The single sensor holes may be substantially circular or round or may be shaped to accommodate a size and shape of the single wire or antenna element.

Holes 540 may be formed in each of the flux sensor core plates 526 for receiving a fastener for assembling a plurality of sensor core plates 526 together in a stack as illustrated in Figure 5.

The electromagnetic device 500 may also include a spacer portion 542 and 544 disposed on each outside flux sensor core plate 526. Each spacer portion 542 and 544 may include a plurality of spacer plates 546 stacked on one another. The spacer plates 546 may be made from a nonmagnetic material or material that is an electrical insulator or dielectric. Referring also to Figure 7, Figure 7 is a top view of an example of a spacer plate 546 or laminate in accordance with an embodiment of the present disclosure. The spacer plate 546 may be substantially "E" shaped as illustrated in Figure 7. The spacer plate 546 may include a main segment 702, a center segment 704 extending from a central portion of the main member 702 and two outer segments 706 and 708 extending from opposite ends of the main segment 702. A plurality of spacer plates 546 stacked to form the spacer portions 542 and 544 provide openings 710 and 712 formed between the two outer segments 706 and 708 and the center segment 704 as in the embodiment illustrated in Figure 7. The primary conductor windings 510 and secondary conductor windings 512 pass or extend through the openings 710 and 712.

Each spacer plate 546 may also include a gap or gaps 714 and 716 for the sensor conductor windings 534 and 538 that pass through each pair of sensor holes 528 and 530 (Figures 5 and 6) to connect to the core flux sensor device 536 for detecting the magnetic flux level at the location of each sensor conductor winding 534 and 538 and associated pair of sensor holes 528 and 530. Each spacer plate 546 may also include holes 718 which will align with holes 540 in the flux sensor core plates 526 to receive holding devices or fasteners for holding the components of the electromagnetic device 500 together.

The electromagnetic device 500 also includes a magnetic core portion 548 and 550 respectively disposed on each spacer portion 542 and 544. The elongated openings 506 and 508 extend through each magnetic core portion 548 and 550 and the primary and secondary conductor windings 510 and 512 extend or pass through each magnetic core portion 548 and 550.

Each magnetic core portion 548 and 550 may include a plurality of magnetic core plates 552 or laminates stacked on one another as illustrated in the exemplary embodiment in Figure 5. The plates 552 may be made from the same material as the sensor plates 524 that are capable of absorbing a magnetic flux as described herein. Referring also to Figure 8, Figure 8 is a top view of an example of a magnetic core plate 552 or laminate in accordance with an embodiment of the present disclosure. The magnetic core plate 552 includes a first elongated opening 802 which corresponds to opening 506 in Figure 5 and a second elongated opening 804 which corresponds to opening 508. The second elongated opening 804 may be parallel to the first elongated opening 802 to permit the conductor winding or windings 510 and 512 to pass through the stacked magnetic core plates 552 forming the magnetic core portions 548 and 550. The openings 802 and 804 in each magnetic core plate 552 respectively form the openings 506 and 508 when the magnetic core plates or laminates are stacked together to form the magnetic core portions 548 and 550.

Each magnetic core plate 552 may also include a plurality of holes 806 which align with the openings 718 in the spacer plates 546 and openings 540 in the flux sensor core plates 526 for receiving a fastener or the like for assembling the magnetic flux core 504 of the electromagnetic device 500 (Figure 5).

The core flux control system 502 (Figure 5) may include a local manager 554 which may also be referred to as a core flux control device or may include a core flux control device similar to that described in U.S. Patent Application Publication No. 2015/0028827. The local manager 554 may be similar to the local mangers 110 in Figure 1, 210 in Figure 2 and 412 in Figure 4. The local manager 554 may be configured to adjust the electrical current flowing through the primary conductor winding 510 to control the magnetic flux level in the magnetic flux core 504 of the electromagnetic device 500. The local manager 554 may be coupled to the primary winding 510 and may receive control input signals corresponding to the magnetic flux level from the core flux sensor device 536. The local manager 554 may adjust the electrical current flowing through the primary conductor winding 510 in response to the magnetic flux level detected or measured by the core flux sensor device 536. Similar to that previously described, the local manager 554 may be configured to transmit magnetic flux level data sensed by the core flux sensor arrangement 522 to a central manager, such as central manager 102 in Figure 1. The local manager 554 may then receive instructions from the central manager for configuring the electromagnetic device 500 or transformer similar to that described herein. The local manager 554 may configure the electromagnetic device by adjusting a number of turns in the primary conductor winding 510 so that a predetermined magnetic flux level may be maintained in the magnetic flux core 504. In accordance with an embodiment, the core flux control system 502 may include an additional winding or a control winding 556 or windings through the openings 506 and 508 of the magnetic core 504. The control winding 504 is coupled to the local manager 554. The local manager 554 may be adapted to connect the electrical power source 514 to the control winding 556 or windings and thereby adjust the number of turns of the primary winding 510. The local manager 554 in addition to being able to switch in or out the additional primary winding or control winding 556, may also control the amplitude or amount of current flowing in the control winding 556 to control the level of magnetic flux flow in the core 504 in response to signals or instructions from the central manager 106 Figure 1 and/or based on the magnetic flux level in the core 504 sensed by the core flux sensor arrangement 522.

The core flux sensor arrangement 522 may detect the magnetic flux level in the magnetic flux core 504 when a peak source current is flowing through the primary conductor winding 510. The local manger 554 may be configured to increase the electrical current flow through the primary conductor winding 510 and/or control winding 556 in response to the magnetic flux level being lower than a predetermined level for the peak source current and to reduce the electrical current flowing through the primary conductor winding 510 and/or control winding 556 in response to the level of the magnetic flux flow being higher than the predetermined level for the peak current.

Figure 9 is a flow chart of an example of a method 900 for monitoring a magnetic core flux level in one or more transformers of an electrical power distribution network and controlling power distribution by the network in accordance with an embodiment of the present disclosure. The method 900 may be embodied in any of the local managers 106 described with reference to Figure 1 or the similar local managers described with reference to the other Figures. In block 902, the magnetic core flux level in one or more transformers in an electrical power distribution network or system may be monitored in real time. The magnetic flux level may be monitored by a local manager associated with each transformer and the magnetic flux level data may be transmitted to a central manager by the local manager for analysis as previously described.

In block 904, the magnetic flux core level data may be collected from each transformer monitored in the electrical power distribution network. The magnetic flux core level data may be collected by a central manager.

In block 906, any anomalies may be detected based on the monitored and collected magnetic core flux level data. For example, any faults or potential faults or other conditions that could result in possible harm to components of the electrical power distribution network or to equipment of consumers connected to the electrical power distribution network may be detected. The electrical power distribution network may be reconfigured to isolate any faults or other harmful conditions in response to any faults, potential faults or other conditions.

In block 908, any changes or trends in the magnetic core flux level data may be analyzed for all the transformers in the electrical power distribution network or system which are being monitored.

In block 910, the power distribution network or system may be reconfigured in response to at least the core flux level data. The network may be reconfigured by adjusting electrical source current flowing through the primary conductor windings in a selected transformer or transformers to control the magnetic core flux level in the selected transformer or transformers of the distribution network. Control signals may be transmitted from a central manager to a local manager or managers associated with the transformers being controlled or reconfigured as described herein. The method 900 may return to block 902 and the magnetic core flux level may continue to be monitored in one or more transformers in real time. The method 900 may then continue similar to that previously described.

Figure 10 is a flow chart of an example of a method 1000 for controlling magnetic flux in an electromagnetic device for power management in accordance with an embodiment of the present disclosure. The method of 1000 may be performed by the electromagnetic device 500 and the core flux control system 502 of Figure 5 or a similar system. In block 1002, a magnetic flux flow in a magnetic flux core may be detected and a level of the magnetic flux flow in the core measured. As previously described, a core flux sensor arrangement may detect the magnetic flux flow and level in the magnetic flux core. At least one pair of sensor holes may be formed in at least a portion of the magnetic core similar to that previously described and a sensor conductor winding may be passed through the at least one pair of sensor holes forming a loop sensor antenna for detecting the magnetic flux flow and level. The magnetic flux flow causes an electrical signal to be generated in the sensor conductor winding or loop antenna. An amplitude of the electrical signal corresponds to the magnetic flux level in the magnetic flux core.

In block 1004, an electrical current flowing through a conductor winding passing through the magnetic flux core may be adjusted in response to the magnetic flux level detected or measured to control the magnetic flux level in the core. Alternatively or in addition, electrical current in a control winding may be adjusted in response to the magnetic flux level detected or measured in the core to control the flux flow level in the core by increasing or decreasing the current. The magnetic flux level may also be controlled or adjusted by adjusting the number of turns of the primary winding to maintain a predetermined magnetic flux level.

In block 1006, electrical current flowing in a primary conductor winding or a control winding may be increased in response to the magnetic flux level being lower than a predetermined level for a peak source current.

In block 1008, electrical current flowing in a primary conductor winding or a control winding may be reduced in response to the magnetic flux level being higher than the predetermined level or the peak source current.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Although specific embodiments have been illustrated and described herein, those of ordinary skill in the art appreciate that any arrangement which is calculated to achieve the same purpose may be substituted for the specific embodiments shown and that the embodiments herein have other applications in other environments. This application is intended to cover any adaptations or variations of the present disclosure. The following claims are in no way intended to limit the scope of the disclosure to the specific embodiments described herein.

## Claims

1. An electrical power distribution network (100), comprising:
a plurality of transformers (108; 208; 400; 500);
a local manager (110; 210; 412; 554) associated with a transformer (108; 208; 400; 500);
a core flux sensor arrangement (114; 214; 404; 522) coupled to each local manager (110; 210; 412; 554), the core flux sensor arrangement configured to detect a magnetic flux level in a magnetic flux core of the associated transformer;
each local manager (108; 208; 400; 500) configured to monitor and control the magnetic flux level in the magnetic flux core of the associated transformer (108; 208; 400; 500); and
a central manager (106; 206) configured to receive and analyze magnetic flux level data from each local manager (110; 210; 412; 554) and transmit an individual instruction to at least some local managers (108; 208; 400; 500) for controlling the magnetic flux level in the associated transformer (108; 208; 400; 500) in response to the analysis of the magnetic flux level data.

2. The electrical power distribution network of claim 1, wherein the central manager is configured to integrate the magnetic flux level data from each of the local managers and evaluate performance of the electrical power distribution network.

3. The electrical power distribution network of claim 1, wherein the central manager is configured to detect a fault from analysis of the magnetic flux level data and to isolate the fault by transmitting an instruction to the local manager associated with the fault, the local manger configuring the associated transformer to isolate the fault in response to the instruction.

4. The electrical power distribution network of claim 1, further comprising a network model associated with the central manager, wherein the central manager is configured to modify the network model to match a configuration of the electrical power distribution network in response to a change in the configuration of the electrical power distribution network.

5. The electrical power distribution network of claim 1, wherein the local manager is configured to receive the magnetic flux level
data and to adjust an electrical current flowing through a conductor winding of the associated transformer to control the magnetic flux flow in the magnetic flux core.

6. The electrical power distribution network of claim 1, wherein each transformer comprises:
a magnetic flux core;
an opening through the magnetic flux core;
a conductor winding received in the opening and extending through the magnetic flux core, wherein an electrical current flowing through the conductor winding generates a magnetic field about the conductor winding and a magnetic flux flow about the opening in the magnetic flux core; and
the core flux sensor arrangement to detect the magnetic flux flow in the magnetic flux core, the local manager being configured to receive the magnetic flux level data from the core flux sensor arrangement and to adjust the electrical current flowing through the conductor winding of the associated transformer to control the magnetic flux flow in the magnetic flux core.

7. The electrical power distribution network of claim 6, 5 wherein the core flux sensor arrangement comprises:
a first pair of sensor holes formed through at least a portion of the magnetic flux core, the first pair of sensor holes being positioned relative to the opening through the magnetic flux core for use in sensing the magnetic flux flow while minimizing disruption of the magnetic flux flow in the magnetic flux core; and
a first sensor conductor winding through the first pair of sensor holes, the magnetic flux flow generating a first electrical signal in the first sensor conductor winding, the first electrical signal in the first sensor conductor winding corresponding to the magnetic flux flow at a location of the first sensor conductor winding.

8. The electrical power distribution network of claim 7, wherein the core flux sensor arrangement comprises:
a second pair of sensor holes formed through at least the portion of the magnetic flux core at a greater distance from the opening than the pair of sensor holes, the second pair of sensor holes for use in sensing the magnetic flux flow at a location of the second pair of sensor holes; and
a second sensor conductor winding through the second pair of sensor holes, the magnetic flux flow generating a second electrical signal in the second sensor conductor winding, the second electrical signal in the second sensor conductor winding corresponding to the magnetic flux flow at the location of the second sensor conductor winding.

9. A transformer (500) for use in a power distribution network (100), comprising:
a magnetic flux core (504);
an opening (506; 508) through the magnetic flux core (504);
a conductor winding (510) received in the opening (500) and extending through the magnetic flux core (504), wherein an electrical current flowing through the conductor winding (510) generates a magnetic field about the conductor winding (510) and a magnetic flux flow about the opening (506; 508) in the magnetic flux core (504);
a core flux sensor arrangement (522) to detect a magnetic flux level in the magnetic flux core (504); and
a local manager (554) configured to adjust the electrical current flowing through the conductor winding (510) to control the magnetic flux level in the magnetic flux core (504) and the local manager (554) configured to transmit magnetic flux level data to a central manager of the power distribution network (100) and to receive instructions from the central manager (106) to control the magnetic flux level in the magnetic flux core (504).

10. The transformer of claim 9, wherein the core flux sensor arrangement comprises:
a first pair of sensor holes formed through at least a portion of the magnetic flux core, the first pair of sensor holes being positioned relative to the opening through the magnetic flux core for use in sensing the magnetic flux flow while minimizing disruption of the magnetic flux flow in the magnetic flux core; and
a first sensor conductor winding through the first pair of sensor holes, the magnetic flux flow generating a first electrical signal in the first sensor conductor winding, the first electrical signal in the first sensor conductor winding corresponding to the magnetic flux flow at a location of the first sensor conductor winding.

11. The transformer of claim 10, wherein the core flux sensor arrangement comprises:
a second pair of sensor holes formed through at least the portion of the magnetic flux core at a greater distance from the opening than the pair of sensor holes, the second pair of sensor holes for use in sensing the magnetic flux flow at a location of the second pair of sensor holes; and
a second sensor conductor winding through the second pair of sensor holes, the magnetic flux flow generating a second electrical signal in the second sensor conductor winding, the second electrical signal in the second sensor conductor winding corresponding to the magnetic flux flow at the location of the second sensor conductor winding.

12. The transformer of claim 9, wherein the local manager is adapted to adjust a number of turns in the conductor winding to maintain a predetermined magnetic flux level in the magnetic flux core.

13. The transformer of claim 9, further comprising a control winding through at least a portion of the magnetic flux core, wherein the local manager increases or decreases an amount of electrical current flowing in the control winding to control the magnetic flux level in the core.

14. A method (900) for monitoring and controlling operation of an electrical power distribution network:
providing monitoring (902) and control of a magnetic flux level in a magnetic flux core of each of a plurality of transformers of the electrical power distribution network, wherein the magnetic flux level is monitored by a local manager associated with a transformer, wherein a core flux sensor arrangement (114) is coupled to each local manager, the core flux sensor arrangement detecting the magnetic flux level of the associated transformer;
collecting (904) magnetic flux level data from each of the plurality of transformers, wherein the magnetic flux core level data is collected by a central manager; and
reconfiguring (910) the power distribution system in response to the magnetic flux level data to prevent harm to the electrical power distribution network and any equipment coupled to the power distribution network.

15. The method of claim 14, wherein reconfiguring the power distribution system comprises removing electrical power from a component in response to determining that an amount of electrical power exceeding a predetermined threshold is about to be applied to the component.

16. The method of claim 14, further comprising:
adjusting an electrical source current flowing through a conductor winding extending through an opening in the magnetic flux core of each transformer to control the magnetic flux level in the magnetic flux core, an amplitude of the electrical source current flowing through the conductor winding corresponds to the magnetic flux level.

17. The method of claim 16, further comprising:
providing a pair of sensor holes formed through at least a portion of the magnetic flux core of each transformer, the pair of sensor holes being positioned relative to the opening through the magnetic flux core, the pair of sensor holes being used in sensing the magnetic flux level while minimizing disruption of a magnetic flux flow in the magnetic flux core; and
providing a sensor conductor winding through the pair of sensor holes, the magnetic flux flow generating an electrical signal in the sensor conductor winding, an amplitude of the electrical signal in the sensor conductor winding corresponding to the magnetic flux flow at a location of the sensor conductor winding.

## Patentansprüche

1. Elektrisches Energieverteilungsnetz (100), umfassend:
eine Vielzahl von Transformatoren (108; 208; 400; 500);
einen lokalen Manager (110; 210; 412; 554), der einem Transformator (108; 208; 400; 500) zugeordnet ist;
eine Kernflusssensoranordnung (114; 214; 404; 522), die mit jedem lokalen Manager (110; 210; 412; 554) gekoppelt ist, wobei die Kernflusssensoranordnung konfiguriert ist, um einen Magnetflusspegel in einem Magnetflusskern des zugehörigen Transformators zu erfassen;
wobei jeder lokale Manager (108; 208; 400; 500) konfiguriert ist, um den Magnetflusspegel im Magnetflusskern des zugehörigen Transformators (108; 208; 400; 500) zu überwachen und zu steuern; und
einen zentralen Manager (106; 206), der konfiguriert ist, um Magnetflusspegeldaten von jedem lokalen Manager (110; 210; 412; 554) zu empfangen und zu analysieren und eine individuelle Anweisung an mindestens einige lokale Manager (108; 208; 400; 500) zu senden, um den Magnetflusspegel in dem zugehörigen Transformator (108; 208; 400; 500) als Reaktion auf die Analyse der Magnetflusspegeldaten zu steuern.

2. Elektrisches Energieverteilungsnetz nach Anspruch 1, bei dem der zentrale Manager konfiguriert ist, um die Daten des magnetischen Flusspegels von jedem der lokalen Manager zu integrieren und die Leistungsfähigkeit des elektrischen Energieverteilungsnetzes zu bewerten.

3. Elektrisches Energieverteilungsnetz nach Anspruch 1, bei dem der zentrale Manager konfiguriert ist, um einen Fehler aus der Analyse der Daten des magnetischen Flusspegels zu erkennen und den Fehler zu isolieren, indem er eine Anweisung an den dem Fehler zugeordneten lokalen Manager sendet, wobei der lokale Manager den zugehörigen Transformator konfiguriert, um als Reaktion auf den Befehl den Fehler zu isolieren.

4. Elektrisches Energieverteilungsnetz nach Anspruch 1, ferner umfassend ein dem zentralen Manager zugeordnetes Netzwerkmodell, wobei der zentrale Manager konfiguriert ist, um in Reaktion auf eine Änderung in einer Konfiguration des elektrischen Energieverteilungsnetzes das Netzwerkmodell an die Konfiguration des elektrischen Energieverteilungsnetzes anzupassen.

5. Elektrisches Energieverteilungsnetz nach Anspruch 1, wobei der lokale Manager konfiguriert ist, um die Magnetflusspegeldaten zu empfangen und einen elektrischen Strom einzustellen, der durch eine Leiterwicklung des zugehörigen Transformators fließt, um den Magnetflussstrom im Magnetflusskern zu steuern.

6. Elektrisches Energieverteilungsnetz nach Anspruch 1, bei dem jeder Transformator umfasst:
einen Magnetflusskern;
eine Öffnung durch den Magnetflusskern;
eine Leiterwicklung, die in der Öffnung aufgenommen ist und sich durch den Magnetflusskern erstreckt, wobei ein elektrischer Strom, der durch die Leiterwicklung fließt, ein Magnetfeld um die Leiterwicklung und einen Magnetflussstrom um die Öffnung im Magnetflusskern erzeugt; und
die Kernflusssensoranordnung zum Erfassen des Magnetflussstroms im Magnetflusskern,
wobei der lokale Manager konfiguriert ist, um die Magnetflusspegeldaten von der Kernflusssensoranordnung zu empfangen und den elektrischen Strom, der durch die Leiterwicklung des zugehörigen Transformators fließt, einzustellen, um den Magnetfluss im Magnetflusskern zu steuern.

7. Elektrisches Energieverteilungsnetz nach Anspruch 6, 5, bei dem die Kernfluss-Sensoranordnung umfasst:
ein erstes Paar von Sensorlöchern, die sich durch mindestens einen Abschnitt des Magnetflusskerns erstrecken, wobei das erste Paar von Sensorlöchern relativ zu der Öffnung durch den Magnetflusskern positioniert ist, um den Magnetfluss zu erfassen und gleichzeitig die Unterbrechung des Magnetflussstroms im Magnetflusskern zu minimieren; und
eine erste Sensorleiterwicklung durch das erste Paar von Sensorlöchern, wobei der Magnetflussstrom ein erstes elektrisches Signal in der ersten Sensorleiterwicklung erzeugt, wobei das erste elektrische Signal in der ersten Sensorleiterwicklung dem Magnetflussstrom an einer Stelle der ersten Sensorleiterwicklung entspricht.

8. Elektrisches Energieverteilungsnetz nach Anspruch 7, worin die Kernfluss-Sensoranordnung umfasst:
ein zweites Paar von Sensorlöchern, die sich durch mindestens den Abschnitt des Magnetflusskerns in einem größeren Abstand von der Öffnung als das Paar von Sensorlöchern erstrecken, wobei das zweite Paar von Sensorlöchern zum Erfassen des Magnetflussstroms an einer Stelle des zweiten Paares von Sensorlöchern verwendet wird; und
eine zweite Sensorleiterwicklung durch das zweite Paar von Sensorlöchern, wobei der Magnetflussstrom ein zweites elektrisches Signal in der zweiten Sensorleiterwicklung erzeugt, wobei das zweite elektrische Signal in der zweiten Sensorleiterwicklung dem Magnetflussstrom an der Stelle der zweiten Sensorleiterwicklung entspricht.

9. Transformator (500) zur Verwendung in einem Energieverteilungsnetz (100), umfassend:
einen Magnetflusskern (504);
eine Öffnung (506; 508) durch den Magnetflusskern (504);
eine Leiterwicklung (510), die in der Öffnung (500) aufgenommen ist und sich durch den Magnetflusskern (504) erstreckt, wobei ein elektrischer Strom, der durch die Leiterwicklung (510) fließt, ein Magnetfeld um die Leiterwicklung (510) und einen Magnetflussstrom um die Öffnung (506; 508) in dem Magnetflusskern (504) erzeugt;
eine Kernflusssensoranordnung (522) zum Erfassen eines Magnetflusspegels in dem Magnetflusskern (504); und
einen lokalen Manager (554), der konfiguriert ist, um den elektrischen Strom einzustellen, der durch die Leiterwicklung (510) fließt, um den Magnetflusspegel in dem Magnetflusskern (504) zu steuern, wobei der lokale Manager (554) konfiguriert ist, um Magnetflusspegeldaten an einen zentralen Manager des Energieverteilungsnetzes (100) zu übertragen und Anweisungen von dem zentralen Manager (106) zum Steuern des Magnetflusspegels in dem Magnetflusskern (504) zu empfangen.

10. Transformator nach Anspruch 9, bei dem die Kernfluss-Sensoranordnung umfasst:
ein erstes Paar von Sensorlöchern, die sich durch mindestens einen Abschnitt des Magnetflusskerns erstrecken, wobei das erste Paar von Sensorlöchern relativ zu der Öffnung durch den Magnetflusskern positioniert ist, um den Magnetflussstrom zu erfassen und gleichzeitig die Unterbrechung des Magnetflussstroms im Magnetflusskern zu minimieren; und
eine erste Sensorleiterwicklung durch das erste Paar von Sensorlöchern, wobei der Magnetfluss ein erstes elektrisches Signal in der ersten Sensorleiterwicklung erzeugt, wobei das erste elektrische Signal in der ersten Sensorleiterwicklung dem Magnetflussstrom an einer Stelle der ersten Sensorleiterwicklung entspricht.

11. Transformator nach Anspruch 10, bei dem die Kernfluss-Sensoranordnung umfasst:
ein zweites Paar von Sensorlöchern, die sich durch mindestens den Abschnitt des Magnetflusskerns in einem größeren Abstand von der Öffnung als das Paar von Sensorlöchern erstrecken, wobei das zweite Paar von Sensorlöchern zum Erfassen des Magnetflusses an einer Stelle des zweiten Paares von Sensorlöchern verwendet wird; und
eine zweite Sensorleiterwicklung durch das zweite Paar von Sensorlöchern, wobei der Magnetflussstrom ein zweites elektrisches Signal in der zweiten Sensorleiterwicklung erzeugt, wobei das zweite elektrische Signal in der zweiten Sensorleiterwicklung dem Magnetflussstrom an der Stelle der zweiten Sensorleiterwicklung entspricht.

12. Transformator nach Anspruch 9, bei dem der lokale Manager eingerichtet ist, um eine Anzahl von Windungen in der Leiterwicklung einzustellen, um einen vorbestimmten magnetischen Flusspegel im Magnetflusskern aufrechtzuerhalten.

13. Transformator nach Anspruch 9, ferner umfassend eine Steuerwicklung durch mindestens einen Abschnitt des Magnetflusskerns, bei dem der lokale Manager eine Menge an elektrischem Strom, der in der Steuerwicklung fließt, erhöht oder verringert, um den Magnetflusspegel in dem Kern zu steuern.

14. Verfahren (900) zum Überwachen und Steuern des Betriebs eines elektrischen Energieverteilungsnetzes, mit den Schritten:
Bereitstellen einer Überwachung (902) und Steuerung eines magnetischen Flusspegels in einem Magnetflusskern eines jeden aus einer Mehrzahl von Transformatoren des elektrischen Energieverteilungsnetzes,
wobei der Magnetflusspegel von einem lokalen Manager überwacht wird, der einem Transformator zugeordnet ist, wobei eine Kernflusssensoranordnung (114) mit jedem lokalen Manager gekoppelt ist, und die Kernflusssensoranordnung den Magnetflusspegel des zugehörigen Transformators erfasst;
Sammeln (904) von Magnetflusspegeldaten von jedem der Mehrzahl von Transformatoren,
wobei die Magnetflusskernpegeldaten von einem zentralen Manager gesammelt werden; und
Rekonfigurieren (910) des Energieverteilungssystems als Reaktion auf die Daten des magnetischen Flusspegels, um Schäden am elektrischen Energieverteilungsnetz und an beliebigen mit dem Energieverteilungsnetz gekoppelten Geräten zu verhindern.

15. Verfahren nach Anspruch 14, bei dem das Rekonfigurieren des Energieverteilungssystems das Entfernen von elektrischer Energie von einer Komponente als Reaktion auf die Feststellung umfasst, dass eine Menge an elektrischer Energie an die Komponente angelegt werden soll, die einen vorbestimmten Schwellenwert überschreitet.

16. Verfahren nach Anspruch 14, ferner mit dem Schritt:
Einstellen eines elektrischen Quellenstroms, der durch eine Leiterwicklung fließt, die sich durch eine Öffnung im Magnetflusskern jedes Transformators erstreckt, um den Magnetflusspegel im Magnetflusskern zu steuern, wobei eine Amplitude des durch die Leiterwicklung fließenden elektrischen Quellenstroms dem Magnetflusspegel entspricht.

17. Verfahren nach Anspruch 16, ferner mit den Schritten:
Bereitstellen eines Paares von Sensorlöchern, die sich durch mindestens einen Abschnitt des Magnetflusskerns jedes Transformators erstrecken, wobei das Paar von Sensorlöchern relativ zu der Öffnung durch den Magnetflusskern positioniert ist, wobei das Paar von Sensorlöchern verwendet wird, um den Magnetflusspegel zu erfassen und gleichzeitig die Unterbrechung eines Magnetflussstroms im Magnetflusskern zu minimieren; und
Bereitstellen einer Sensorleiterwicklung durch das Paar von Sensorlöchern, wobei der Magnetflussstrom ein elektrisches Signal in der Sensorleiterwicklung erzeugt, wobei eine Amplitude des elektrischen Signals in der Sensorleiterwicklung dem Magnetflussstrom an einer Stelle der Sensorleiterwicklung entspricht.

## Revendications

1. Réseau de distribution d'énergie électrique (100), comprenant :
une pluralité de transformateurs (108 ; 208 ; 400 ; 500) ;
un gestionnaire local (110 ; 210 ; 412 ; 554) associé à un transformateur (108 ; 208 ; 400 ; 500) ;
un agencement de capteur de flux de noyau (114 ; 214 ; 404 ; 522) couplé à chaque gestionnaire local (110 ; 210 ; 412 ; 554), l'agencement de capteur de flux de noyau étant configuré de manière à détecter un niveau de flux magnétique dans un noyau de flux magnétique du transformateur associé ;
chaque gestionnaire local (108 ; 208 ; 400 ; 500) étant configuré de manière à surveiller et commander le niveau de flux magnétique dans le noyau de flux magnétique du transformateur associé (108 ; 208 ; 400 ; 500) ; et
un gestionnaire central (106 ; 206) configuré de manière à recevoir et analyser des données de niveau de flux magnétique en provenance de chaque gestionnaire local (110 ; 210 ; 412 ; 554), et à transmettre une instruction individuelle à au moins certains gestionnaires locaux (108 ; 208 ; 400 ; 500) visant à commander le niveau de flux magnétique dans le transformateur associé (108 ; 208 ; 400 ; 500) en réponse à l'analyse des données de niveau de flux magnétique.

2. Réseau de distribution d'énergie électrique selon la revendication 1, dans lequel le gestionnaire central est configuré de manière à intégrer les données de niveau de flux magnétique provenant de chacun des gestionnaires locaux et à évaluer les performances du réseau de distribution d'énergie électrique.

3. Réseau de distribution d'énergie électrique selon la revendication 1, dans lequel le gestionnaire central est configuré de manière à détecter un défaut à partir de l'analyse des données de niveau de flux magnétique, et à isoler le défaut en transmettant une instruction au gestionnaire local associé au défaut, le gestionnaire local configurant le transformateur associé pour isoler le défaut en réponse à l'instruction.

4. Réseau de distribution d'énergie électrique selon la revendication 1, comprenant en outre un modèle de réseau associé au gestionnaire central, dans lequel le gestionnaire central est configuré de manière à modifier le modèle de réseau en vue d'obtenir une correspondance avec une configuration du réseau de distribution d'énergie électrique en réponse à une modification apportée dans la configuration du réseau de distribution d'énergie électrique.

5. Réseau de distribution d'énergie électrique selon la revendication 1, dans lequel le gestionnaire local est configuré de manière à recevoir les données de niveau de flux magnétique et à ajuster un courant électrique circulant à travers un enroulement conducteur du transformateur associé en vue de commander l'écoulement de flux magnétique dans le noyau de flux magnétique.

6. Réseau de distribution d'énergie électrique selon la revendication 1, dans lequel chaque transformateur comprend :
un noyau de flux magnétique ;
une ouverture à travers le noyau de flux magnétique ;
un enroulement conducteur reçu dans l'ouverture et s'étendant à travers le noyau de flux magnétique, dans lequel un courant électrique circulant à travers l'enroulement conducteur génère un champ magnétique autour de l'enroulement conducteur et un écoulement de flux magnétique autour de l'ouverture dans le noyau de flux magnétique ; et
l'agencement de capteur de flux de noyau étant destiné à détecter l'écoulement de flux magnétique dans le noyau de flux magnétique, le gestionnaire local étant configuré de manière à recevoir les données de niveau de flux magnétique en provenance de l'agencement de capteur de flux de noyau et à ajuster le courant électrique circulant à travers l'enroulement conducteur du transformateur associé, en vue de commander l'écoulement de flux magnétique dans le noyau de flux magnétique.

7. Réseau de distribution d'énergie électrique selon la revendication 5 ou 6, dans lequel l'agencement de capteur de flux de noyau comprend :
une première paire de trous de capteur formée à travers au moins une partie du noyau de flux magnétique, la première paire de trous de capteur étant positionnée par rapport à l'ouverture à travers le noyau de flux magnétique en vue d'être utilisée pour détecter l'écoulement de flux magnétique tout en minimisant une perturbation de l'écoulement de flux magnétique dans le noyau de flux magnétique ; et
un premier enroulement conducteur de capteur à travers la première paire de trous de capteur, l'écoulement de flux magnétique générant un premier signal électrique dans le premier enroulement conducteur de capteur, le premier signal électrique dans le premier enroulement conducteur de capteur correspondant à l'écoulement de flux magnétique à un emplacement du premier enroulement conducteur de capteur.

8. Réseau de distribution d'énergie électrique selon la revendication 7, dans lequel l'agencement de capteur de flux de noyau comprend :
une seconde paire de trous de capteur formé à travers au moins la partie du noyau de flux magnétique, à une plus grande distance de l'ouverture que la paire de trous de capteur, la seconde paire de trous de capteur étant utilisée en vue de détecter l'écoulement de flux magnétique à un emplacement de la seconde paire de trous de capteur ; et
un second enroulement conducteur de capteur à travers la seconde paire de trous de capteur, l'écoulement de flux magnétique générant un second signal électrique dans le second enroulement conducteur de capteur, le second signal électrique dans le second enroulement conducteur de capteur correspondant à l'écoulement de flux magnétique à l'emplacement du second enroulement conducteur de capteur.

9. Transformateur (500) destiné à être utilisé dans un réseau de distribution d'énergie électrique (100), comprenant :
un noyau de flux magnétique (504) ;
une ouverture (506 ; 508) dans le noyau de flux magnétique (504) ;
un enroulement conducteur (510) reçu dans l'ouverture (500) et s'étendant à travers le noyau de flux magnétique (504), dans lequel un courant électrique circulant à travers l'enroulement conducteur (510) génère un champ magnétique autour de l'enroulement conducteur (510) et un écoulement de flux magnétique autour de l'ouverture (506 ; 508) dans le noyau de flux magnétique (504) ;
un agencement de capteur de flux de noyau (522) pour détecter un niveau de flux magnétique dans le noyau de flux magnétique (504) ; et
un gestionnaire local (554) configuré de manière à ajuster le courant électrique circulant à travers l'enroulement conducteur (510) en vue de commander le niveau de flux magnétique dans le noyau de flux magnétique (504), et le gestionnaire local (554) configuré de manière à transmettre des données de niveau de flux magnétique à un gestionnaire central du réseau de distribution d'énergie électrique (100) et à recevoir des instructions, en provenance du gestionnaire central (106), visant à commander le niveau de flux magnétique dans le noyau de flux magnétique (504).

10. Transformateur selon la revendication 9, dans lequel l'agencement de capteur de flux de noyau comprend :
une première paire de trous de capteur formée à travers au moins une partie du noyau de flux magnétique, la première paire de trous de capteur étant positionnée par rapport à l'ouverture à travers le noyau de flux magnétique en vue d'être utilisée pour détecter l'écoulement de flux magnétique tout en minimisant une perturbation de l'écoulement de flux magnétique dans le noyau de flux magnétique ; et
un premier enroulement conducteur de capteur à travers la première paire de trous de capteur, l'écoulement de flux magnétique générant un premier signal électrique dans le premier enroulement conducteur de capteur, le premier signal électrique dans le premier enroulement conducteur de capteur correspondant à l'écoulement de flux magnétique à un emplacement du premier enroulement conducteur de capteur.

11. Transformateur selon la revendication 10, dans lequel l'agencement de capteur de flux de noyau comprend :
une seconde paire de trous de capteur formé à travers au moins la partie du noyau de flux magnétique, à une plus grande distance de l'ouverture que la paire de trous de capteur, la seconde paire de trous de capteur étant utilisée en vue de détecter l'écoulement de flux magnétique à un emplacement de la seconde paire de trous de capteur ; et
un second enroulement conducteur de capteur à travers la seconde paire de trous de capteur, l'écoulement de flux magnétique générant un second signal électrique dans le second enroulement conducteur de capteur, le second signal électrique dans le second enroulement conducteur de capteur correspondant à l'écoulement de flux magnétique à l'emplacement du second enroulement conducteur de capteur.

12. Transformateur selon la revendication 9, dans lequel le gestionnaire local est apte à ajuster un nombre de spires dans l'enroulement conducteur en vue de maintenir un niveau de flux magnétique prédéterminé dans le noyau de flux magnétique.

13. Transformateur selon la revendication 9, comprenant en outre un enroulement de commande à travers au moins une partie du noyau de flux magnétique, dans lequel le gestionnaire local augmente ou diminue une quantité de courant électrique circulant dans l'enroulement de commande en vue de commander le niveau de flux magnétique dans le noyau.

14. Procédé (900) de surveillance et de commande du fonctionnement d'un réseau de distribution d'énergie électrique, le procédé comprenant les étapes ci-dessous consistant à :
fournir une surveillance (902) et une commande d'un niveau de flux magnétique dans un noyau de flux magnétique de chaque transformateur d'une pluralité de transformateurs du réseau de distribution d'énergie électrique, dans lequel le niveau de flux magnétique est surveillé par un gestionnaire local associé à un transformateur, dans lequel un agencement de capteur de flux de noyau (114) est couplé à chaque gestionnaire local, l'agencement de capteur de flux de noyau détectant le niveau de flux magnétique du transformateur associé ;
collecter des données de niveau de flux magnétique (904) à partir de chaque transformateur de la pluralité de transformateurs, dans lequel les données de niveau de flux magnétique sont collectées par un gestionnaire central ; et
reconfigurer (910) le système ou réseau de distribution d'énergie électrique en réponse aux données de niveau de flux magnétique, en vue d'éviter tout dommage au réseau de distribution d'énergie électrique et à tout équipement couplé au réseau de distribution d'énergie électrique.

15. Procédé selon la revendication 14, dans lequel l'étape de reconfiguration du système ou réseau de distribution d'énergie électrique comprend l'étape consistant à couper l'alimentation électrique d'un composant en réponse à une détermination selon laquelle une quantité d'énergie électrique dépassant un seuil prédéterminé est sur le point d'être appliquée au composant.

16. Procédé selon la revendication 14, comprenant en outre l'étape ci-dessous consistant à :
ajuster un courant de source électrique circulant à travers un enroulement conducteur s'étendant à travers une ouverture dans le noyau de flux magnétique de chaque transformateur, en vue de commander le niveau de flux magnétique dans le noyau de flux magnétique, dans lequel une amplitude du courant de source électrique circulant à travers l'enroulement conducteur correspond au niveau de flux magnétique.

17. Procédé selon la revendication 16, comprenant en outre les étapes ci-dessous consistant à :
fournir une paire de trous de capteur formée à travers au moins une partie du noyau de flux magnétique de chaque transformateur, la paire de trous de capteur étant positionnée par rapport à l'ouverture à travers le noyau de flux magnétique, la paire de trous de capteur étant utilisée en vue de détecter le niveau de flux magnétique tout en minimisant une perturbation d'un écoulement de flux magnétique dans le noyau de flux magnétique ; et
fournir un enroulement conducteur de capteur à travers la paire de trous de capteur, l'écoulement de flux magnétique générant un signal électrique dans l'enroulement conducteur de capteur, dans lequel une amplitude du signal électrique dans l'enroulement conducteur de capteur correspond à l'écoulement de flux magnétique à un emplacement de l'enroulement conducteur de capteur.
